# EUROPEAN PATENT APPLICATION

(11) **EP 1 848 038 A2**
(43) Date of publication of application: **24.10.2007**
(21) Application number: 07251658.6
(22) Date of filing: 20.04.2007
(51) Int. Cl.: H01L 25/16

(54) **High efficiency led package**

(30) Priority: 20.04.2006 KR 20060035782
(71) Applicant: Alti-electronics Co., Ltd., Cheoin-gu, Yongin-si Gyeonggi-do 449-882 (KR)
(72) Inventor: Park, Ik-Seong, Gwanak-gu, Seoul 151-052 (KR)
(74) Representative: Mounteney, Simon James

(57) **Abstract**

A light emitting diode (LED) package has an LED, which emits light corresponding to an electric signal, a substrate, which is mounted to electrically couple to the LED and has an anode lead frame and a cathode lead frame, a voltage regulator diode, which is mounted on the substrate and has a parallel connection with the LED to maintain voltage regulation, and a shielding dam, which is located between the LED and the voltage regulator diode and prevents light emitted by the LED from being directly irradiated to and reflected or absorbed by the voltage regulator diode. The LED package can prevent the light emitted by the LED from being directly absorbed by the voltage regulator diode.

## Description

### BACKGROUND OF THE INVENTION

### 1. Field of the Invention

The present invention is directed to a light emitting diode package, more specifically to an LED package with a high reflectivity.

### 2. Background Art

Generally, a light emitting diode (LED) refers to an electronic part that makes injected minority carriers (electrons or positive holes) using the p-n junction of a semiconductor and emits light by the re-bonding of these. When a forward direction voltage is applied to a semiconductor of a particular element, the electrons and positive holes move through the junction of an anode and a cathode and become re-bonded. Since the energy becomes smaller than when the electrons and positive holes are separated, light is emitted due to the difference of energy.

LEDs are often used in home appliances, remote controls, electronic billboards, displays, and automation equipment. With telecommunications devices getting increasingly smaller and slimmer, the resistance, condenser, and noise filter are becoming much smaller, and LEDs have become a surface mount device (SMD) type in order for it to be directly mounted on the printed circuit boards.

The SMD type of LED package, which is mainly used for a backlight unit of an LCD in mobile phones, is generally known to be vulnerable to static electricity or reverse voltage. It has been attempted to supplement this vulnerability by providing means for allowing the electric current in the reverse direction, preferably by making a parallel connection between a Zener diode and a light-emitting chip. That is, the light-emitting diode and Zener diode are mounted on the anode and cathode, and the light-emitting diode and Zener diode are connected parallel by a gold (Au) wire.

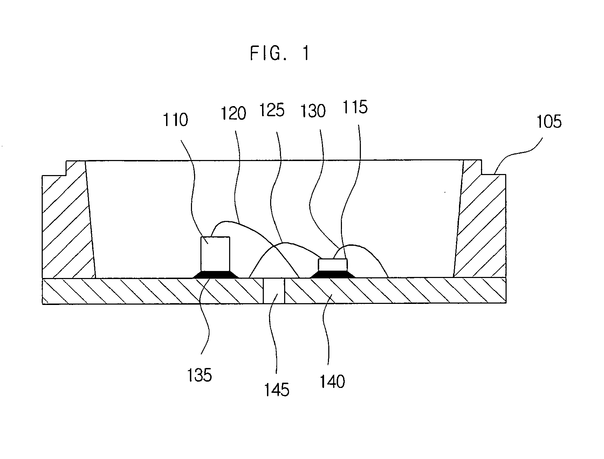

FIG. 1 is a sectional view of an LED package using a voltage regulator diode in accordance with the related art. Referring to FIG. 1, the LED package has a reflecting unit 105, a Zener diode 110, an LED 115, wires 120, 125, and 130, and a substrate. The substrate includes an anode lead frame 135, a cathode lead frame 140, and an insulation area 145.

By making a parallel connection of the Zener diode 110 and the LED 115, the Zener diode can prevent damage caused by static electricity when the current is applied in the reverse direction. The Zener diode is also called a "voltage regulator diode," which is one of the semiconductor PN junction diodes. Designed to show operation properties in a breakdown area of PN junction, the Zener diode is mostly used for voltage regulation. The Zener diode obtains a certain voltage by use of the Zener recovery phenomenon. It operates in 10mA of current in the p-n junction of silicon, and can achieve 3 to 12V of voltage regulation, depending on the type. The Zener diode 110 can be mounted directly on the substrate or by use of the lead frame as shown in FIG. 1.

The Zener diode 110, however, has a problem of absorbing the light emitted by the LED 115, since it is located near the LED 115. In other words, the light-emitting efficiency of the LED package becomes lower as the Zener diode 110 absorbs some of the light of the LED 115 that is directed to the Zener diode 110.

### SUMMARY OF THE INVENTION

The present invention sets out to provide a high efficiency LED package that prevents the light emitted by an LED from being absorbed by a voltage regulator diode.

The present invention also aims to provide a high efficiency LED package in an LED package using a voltage regulator diode without any restriction of usage and use.

The present invention also sets out to provide a high efficiency LED package that can reflect the light that would be otherwise absorbed by the voltage regulator diode.

The present invention also seeks to provide a high efficiency LED package that can emit highly luminous light by adjusting an angle of a reflecting part in the LED package.

Accordingly the invention provides a light emitting diode (LED) package comprising an LED, which emits light corresponding to an electric signal, a substrate, which is mounted to electrically couple to the LED and has an anode lead frame and a cathode lead frame, a voltage regulator diode, which is mounted on the substrate and has a parallel connection with the LED to maintain voltage regulation, and a shielding dam, which is located between the LED and the voltage regulator diode and prevents light emitted by the LED from being directly irradiated to and reflected or absorbed by the voltage regulator diode.

The LED package can be a side view LED.

The voltage regulator diode can be a Zener diode or an avalanche diode.

The shielding dam can be made of one of aluminum, silver and plastic.

The cross section of the shielding dam can be a rectangle or a triangle.

The side of the shielding dam facing the LED can be coated with a reflective material.

The reflective material can be one of aluminum, silver, and plastic.

The side of the shielding dam facing the LED can be tilted at an angle from the substrate.

The LED package in accordance with an embodiment of the present invention can also have a reflecting part, which is formed on the substrate, surrounds the LED, the voltage regulator diode, and the shielding dam, and reflects light emitted by the LED to the outside.

The reflecting side formed on a side of the reflecting part can form an angle from the substrate in accordance with an angle of a side of the shielding dam.

The shielding dam can be made of the same material of the reflecting part.

The shielding dam can be made of poly parabanic acid resin or nylon.

### BRIEF DESCRIPTION OF THE DRAWINGS

These and other features, aspects and advantages of the present invention will become better understood with regard to the following description, appended claims and accompanying drawings where:
FIG. 1 shows a sectional view of an LED package using a voltage regulator diode in accordance with the related art;
FIG. 2 shows a perspective view of a high efficiency LED package in accordance with a first embodiment of the present invention;
FIG. 3 shows a sectional view of the high efficiency LED package in accordance with the first embodiment of the present invention;
FIG. 4 shows a plan view of the high efficiency LED package in accordance with the first embodiment of the present invention;
FIG. 5 is a side sectional view of the high efficiency LED package in accordance with the first embodiment of the present invention;
FIG. 6 shows a circuit schematic of the high efficiency LED package in accordance with the first embodiment of the present invention;
FIG. 7 shows a sectional view of a high efficiency LED package in accordance with a second embodiment of the present invention; and
FIG. 8 shows a sectional view of a high efficiency LED package in accordance with a third embodiment of the present invention.

### DESCRIPTION OF THE EMBODIMENTS

In the present invention, a shielding dam is formed between the LED and the voltage regulator diode to prevent the light emitted by the LED being absorbed by the voltage regulator diode. The shielding dam can be shaped to have a certain angle to reflect the light emitted by the LED to the outside, and can be made of a reflective material or formed with a reflective side to increase reflectivity. Moreover, the LED package can have a reflecting part to increase the luminosity of the light emitted by the LED. The reflecting part can be formed in accordance with the angle of the shielding dam, that is, the section can have a tapered shape.

In the description below, certain embodiments of a high efficiency LED in accordance with the present invention will be described with reference to the accompanying drawings. In the drawings, identical elements will be given the same reference numeral regardless of the figure number, and any redundant description regarding the same element will not be provided. Mainly, three embodiments are described here, based on the shape of the shielding dam formed between the LED and the voltage regulator diode. Although the side view type of LED package will be described, it shall be evident that the present invention can be also applied to other LED packages, such as a top view type, a type used in a flash light, a power LED used in a light. Moreover, although the Zener diode is used to describe the voltage regulator diode, it shall be evident that any device (e.g. an avalanche diode) having an effect of voltage regulation can be applied in the present invention.

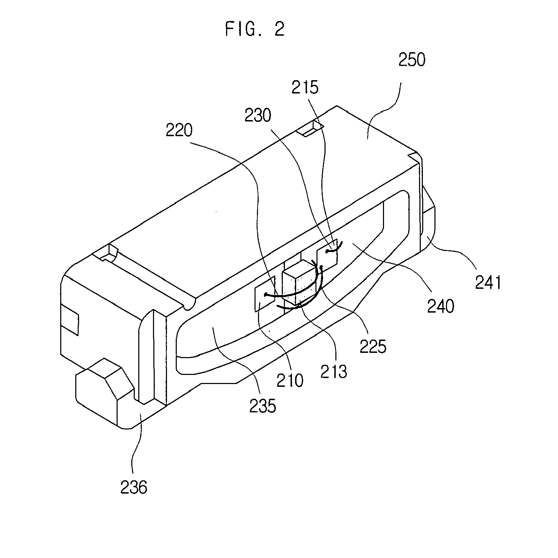

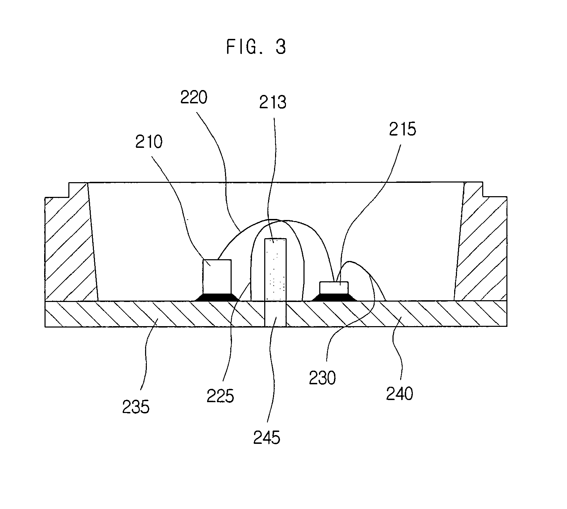

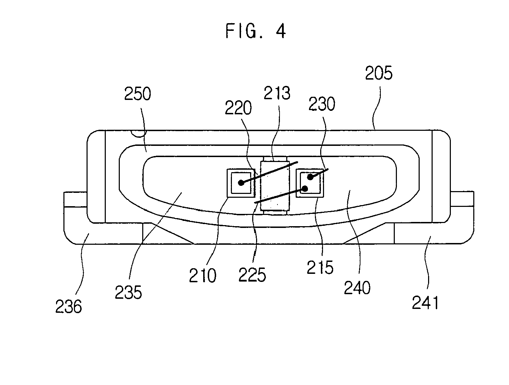

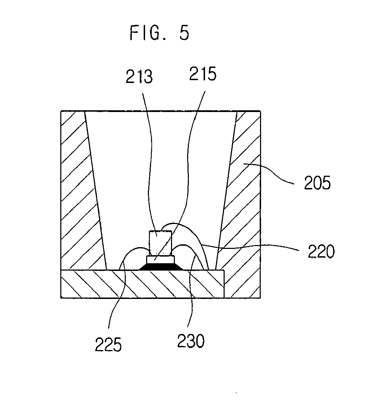

FIG. 2 is a perspective view of a high efficiency LED package in accordance with a first embodiment of the present invention, and FIGS 3, 4, and 5 are a sectional view seen from the front, a plan view seen from the top, and a sectional view seen from the side of the high efficiency LED package shown in FIG. 2. Referring to FIGS. 2 to 5, the high efficiency LED package of the present invention has a projectile body 205, a voltage regulator diode 210, a shielding dam 213, an LED 215, a first wire 220, a second wire 225, a third wire 230, a reflecting part 250, and a substrate. The substrate includes anode lead frames 235 and 236, cathode lead frames 240 and 241, and an insulation area 245.

For the LED 215, a typical LED can be used, preferably from the GaN group. A GaN line of light-emitting chip is designed to irradiate a wavelength band of blue color when emitting light. By applying a fluorescent material producing the light of yellow wavelength band on top of the light-emitting chip, the white light can be made. Here, it is also possible to make the white light by using red, green, and blue fluorescent materials.

The LED package in accordance with the present invention has the LED 215, which is disposed inside the projectile body 205 and irradiates light when electricity is applied, a voltage regulator diode 210, which is for preventing damage caused by static electricity by making a parallel connection with the LED 215, and a reflecting part 250, which reflects the light emitted by the LED 215 to the outside. The projectile body 205 can be made of plastic, especially of poly parabanic acid resin (referred to as "PPA" hereinafter), which has a high mechanical strength and a high reflectivity. The reflecting part 245 is formed on the substrate, surrounding the LED 215, the voltage regulator diode 210, and the shielding dam 213, and can be formed in one body with the projectile body 205 or separately from the projectile body 205. On one side of the projectile body are the anode lead frames 235 and 236 and the cathode lead frames 240 and 241, each of which are protruded. The anode lead frames 235 and 236 and the cathode lead frames 240 and 241 are electrically connected. The voltage regulator diode 210, the shielding dam 213, the LED 215, the first wire 220, the second wire 225, and the third wire 230 are protected by resin, for example, epoxy resin.

The anode lead frame 235 is mounted with the voltage regulator diode 210, and the cathode lead frame 240 with the LED 215. The voltage regulator diode 210 and/or the LED 215 can be mounted by the die bonding method with a conductive epoxy.

The LED can be electrically connected to the anode lead frame 235 through the second wire 225. Therefore, the light can be irradiated from the LED 215 by applying the forward-direction current applied to the cathode lead frame 235 to the LED 215. The highly conductive gold (Au) can be used for the second wire 225.

The voltage regulator diode 210 has a physical property of electrostatic resist pressure against reverse-direction currents. Thus, if reverse-direction currents are applied to the LED 215 by, for example, static electricity, the currents are bypassed by the voltage regulator diode 210, preventing damage by the static electricity. Although the voltage regulator diode 210 includes a Zener diode, any device, such as an avalanche diode, a switching diode, and a schottky diode, having the effect of regulating the voltage can be included.

The voltage regulator diode 210 has the first wire 220, which is extended from the voltage regulator diode 210 and wire-bonded to the cathode lead frame 240. Here, the first wire 220 can be connected to the third wire 230, which is extended form the LED 215, making a parallel connection of the voltage regulator diode 210 to the LED 210.

The shielding dam 213 is located between the voltage regulator diode 210 and the LED 215, and can prevent the light emitted from the LED 215 from directly irradiating on the voltage regulator diode 210 and being reflected directly to or absorbed by the voltage regulator diode 210. Thus, the shielding dam 210 can be made of a reflective material, or the side of the exterior including the side facing the LED 210 can be coated with a reflective material, such that the light emitted by the LED 215 can be efficiently emitted to the outside.

The reflective material forming or coated on the shielding dam 213 can be aluminum (Al) or silver (Ag), which are highly reflective, or can be the highly reflective PPA, which is used to form the projectile body 205, or the highly reflective nylon. If the shielding dam 213 is made of the same material as the material forming the projectile body 205, the shielding dam 213 and the projectile body 205 can be formed by the same process, simplifying the manufacturing process.

A typical LED package having both the voltages regulator diode 210 and the LED 215 generates the light of 1cd if the LED of 1cd is used. With the shielding dam 210 of the present invention, however, the light of about 1.1cd can be generated. To increase the reflection efficiency, the reflecting part 245 of the shielding dam 213 can be formed at an angle from the substrate.

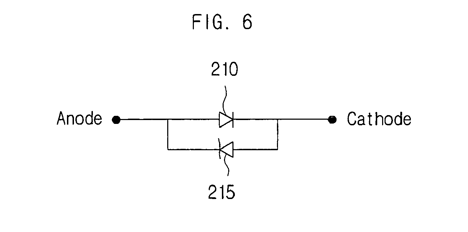

FIG. 6 is a circuit schematic of a high efficiency LED package in accordance with a first embodiment of the present invention. Referring to FIG. 6, the voltage regulator diode 210 and the LED 215 have a parallel connection to the anode lead frame 235 and the cathode lead frame 240.

When the forward-direction current is applied to the LED package, the current is supplied to the LED 215 via the anode lead frame 235 and the first wire 220, making the LED 215 irradiate the light having R, G, and B colors. Since the Zener diode is in the reverse direction, it is electrically open, and thus protects the LED 215 by being short when it is over a certain voltage. Therefore, the LED 215 can have a stable irradiation of light by maintaining the supply of current with the forward-direction voltage (anode to cathode) within a certain range to the LED 215.

If a reverse-direction voltage is applied due to, for example, static electricity, the reverse-direction voltage is supplied to the voltage regulator diode 210, which is electrically a forward direction. The LED 215 is electrically open. Here, if the voltage is applied in the reverse direction, the voltage regulator diode 210 bypasses the current by being short, preventing the LED 215 from being damaged. Therefore, by making a parallel arrangement of the voltage regulator diode 210 with the LED 215, the damage to the LED by the forward-direction and reverse-direction currents can be prevented.

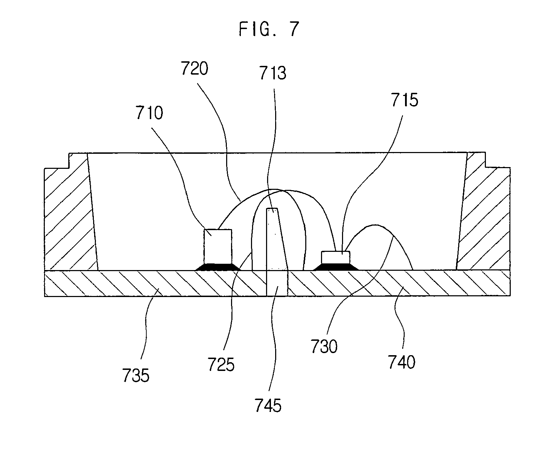

FIG. 7 is a sectional view of a high efficiency LED package in accordance with a second embodiment of the present invention. Referring to FIG. 7, the LED package of the present invention has a voltage regulator diode 710, a shielding dam 713, an LED 715, a first wire 720, a second wire 725, a third wire 730, and a substrate. The substrate includes an anode lead frame 735, a cathode lead frame 740, and an insulation area 745.

The shielding dam 713 is tilted to an angle such that the light emitted by the LED 715 can be efficiently irradiated to the outside. That is, the side on which the shielding dam 713 faces the LED 715 can be tilted at an angle to the substrate (i.e. the anode lead frame 735, the cathode lead frame 740, and the insulation area 745). The tilted side can be a portion of the side or the entire side. The tilt can be formed at an angle by which the reflection efficiency of the light is good. Therefore, the section of the shielding dam 713 can be a shape of a polygon, for example, a rectangle or a triangle.

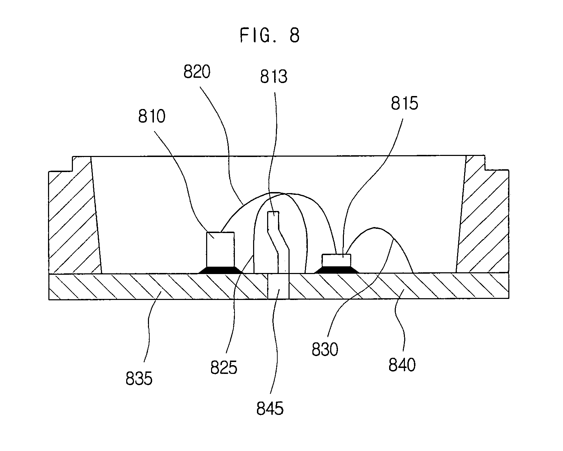

FIG. 8 is a sectional view of a high efficiency LED package in accordance with a third embodiment of the present invention. Referring to FIG. 8, the LED package of the present invention has a voltage regulator diode 810, a shielding dam 813, an LED 815, a first wire 820, a second wire 825, a third wire 830, and a substrate. The substrate includes an anode lead frame 835, a cathode lead frame 840, and an insulation area 845.

The shielding dam 813 can have a shape of a plate which is bent in the middle. That is, to irradiate the light emitted by the LED 815 to the outside efficiently, the shielding dam 813 is shaped as if a plate is bent, requiring less material to form the shielding dam 813. It is evident that any other shape that can efficiently reflect the light emitted by the LED 815 can be applied to the present invention. For example, the entire shielding dam can be slanted to one side, as in a "\" shape.

Although certain embodiments of the present invention have been described, anyone of ordinary skill in the art to which the invention pertains should be able to understand that a very large number of permutations are possible without departing the spirit and scope of the present invention, which shall only be defined by the claims appended below.

## Claims

1. A light emitting diode (LED) package comprising:
an LED, for emitting light corresponding to an electric signal;
a substrate, being mounted to electrically couple to the LED and having an anode lead frame and a cathode lead frame;
a voltage regulator diode, being mounted on the substrate and having a parallel connection with the LED to maintain voltage regulation; and
a shielding dam, being located between the LED and the voltage regulator diode and adapted to prevent light emitted by the LED from being directly irradiated to and reflected or absorbed by the voltage regulator diode.

2. An LED package according to claim 1, in which the LED package is a side view LED.

3. An LED package according to claim 1, in which the voltage regulator diode is a Zener diode or an avalanche diode.

4. An LED package according to claim 1, in which the shielding dam is made of one of aluminum, silver and plastic.

5. An LED package according to claim 1, in which the cross section of the shielding dam is a rectangle or a triangle.

6. An LED package according to claim 1, in which a side of the shielding dam facing the LED is coated with a reflective material.

7. An LED package according to claim 6, in which the reflective material is one of aluminum, silver, and plastic.

8. An LED package according to claim 1, in which a side of the shielding dam facing the LED is tilted at an angle from the substrate.

9. An LED package according to claim 1, further comprising a reflecting part, the reflecting part being formed on the substrate, surrounding the LED, the voltage regulator diode, and the shielding dam, and adapted to reflect light emitted by the LED to the outside.

10. An LED package according to claim 9, in which a reflecting side formed on a side of the reflecting part forms an angle from the substrate in accordance with an angle of a side of the shielding dam.

11. An LED package according to claim 9, in which the shielding dam is made of the same material of the reflecting part.

12. An LED package according to claim 11, in which the shielding dam is made of poly parabanic acid resin or nylon.
